# EUROPEAN PATENT APPLICATION

(11) **EP 2 584 624 A1**
(43) Date of publication of application: **24.04.2013**
(21) Application number: 11185550.8
(22) Date of filing: 18.10.2011
(51) Int. Cl.: H01L 51/50, H01L 51/00

(54) **Method of manufacturing precursor material for forming light emitting region of electroluminescent device**

(71) Applicant: Polyphotonix Limited, Sedgefield County, Durham TS21 3FG (GB)
(72) Inventor: Allott, Richard Mark, Durham TS21 3FG (GB); Bolton, Sean William, Durham TS21 3FG (GB); Miremont, Christophe Olivier, South Queensferry, EH30 9HR (GB); Snell, Thomas, Durham TS21 3FG (GB)
(74) Representative: Vinsome, Rex Martin

(57) **Abstract**

A method of manufacturing a precursor material for use in forming a light emitting region of an electroluminescent device is disclosed. The method comprises providing a mixture of a matrix material and an electroluminescent material, wherein at least part of the matrix material is in a molten state and the mixture includes an organic semiconductor material and an ionic material for providing positive ions and negative ions for contributing to electrochemical doping of the organic semiconductor material.

## Description

The present invention relates to a method of manufacturing a precursor material for use in forming a light emitting region of an electroluminescent device, and relates particularly, but not exclusively, to a method of making a precursor material for use in forming a light emitting region of an organic light emitting diode (OLED). The invention also relates to a method of manufacturing an electroluminescent device from the precursor material.

OLEDs are generally manufactured by forming a series of stacked thin functional layers. An example of a process for forming an OLED is disclosed in EP 1391944, in which a light emitting layer is formed by spraying a solution of an electroluminescent organic semiconductor material onto a substrate. However, this arrangement suffers from the drawback that it is not possible to use the process of EP 1391944 without a substrate, the manufacturing process is complicated and expensive because of the requirement for a substrate, and the requirement of a substrate limits the range of function shapes in which light emitting devices can be made. In addition, the use of thin layers of pure material makes the manufacturing process expensive since the material must be prepared in very clean conditions, and the use of thin films means that light emitting devices manufactured according to the process of EP 1391944 are prone to failure because of impurities.

Preferred embodiments of the present invention seek to overcome one or more of the above disadvantages of the prior art.

According to an aspect of the present invention, there is provided a method of manufacturing a precursor material for use in forming a light emitting region of an electroluminescent device, the method comprising providing a mixture of at least one matrix material and at least one electroluminescent material, wherein at least part of at least one said matrix material is in a molten state and the mixture includes at least one organic semiconductor material and at least one ionic material for providing positive ions and negative ions for contributing to electrochemical doping of at least one said organic semiconductor material.

The present invention is based on the surprising discovery that by providing a mixture of at least one matrix material and at least one electroluminescent material, wherein at least part of at least one said matrix material is in a molten state and the mixture includes at least one organic semiconductor material and at least one ionic material for providing positive ions and negative ions for contributing to electrochemical doping of at least one said organic semiconductor material, this provides the advantage of enabling a light emitting region to be formed from a thicker layer of the precursor material. The ionic material enables an electroluminescent device incorporating the light emitting region to be operated at lower voltages than in the case of a light emitting region from which such materials are absent. As a result, the precursor material can be formed into a wide range of light emitting regions without the need for forming a light emitting layer on a substrate, and the possibility of forming thicker layers enables light emitting devices have light emitting regions incorporating the material to be prepared in less clean conditions than in the case of EP 1391944, thereby reducing the cost of production of such devices.

It will be appreciated by persons skilled in the art that the term "matrix material" is intended to cover a material from which a light emitting region can be formed and in which active components such as electroluminescent material and/or organic semiconductor material are embedded in the electroluminescent device.

At least one said ionic material may comprise at least one organic semiconductor material.

By providing at least one ionic material for use in electrochemical doping of the organic semiconductor material which itself comprises at least one organic semiconductor material, this provides the advantage of reducing the number of materials and processing steps, thereby simplifying the process of manufacturing light emitting devices from the precursor material.

The method may comprise heating at least part of at least one said matrix material to a molten state thereof and adding at least one said electroluminescent material and/or at least one said organic semiconductor material to said matrix material in said molten state.

This provides the advantage of reducing the risk of damage to the electroluminescent material and/or organic semiconductor material by heating.

At least one said electroluminescent material and/or at least one said organic semiconductor material may be added in solution form to said matrix material.

This provides the advantage of improving mixing of the electroluminescent material and/or organic semiconductor material with the matrix material.

The method may further comprise adding at least one plasticiser to at least one said matrix material.

This provides the advantage of reducing the temperature at which the matrix material becomes molten, thereby reducing the risk of damage to the electroluminescent material and/or organic semiconductor material by heating.

The method may further comprise causing solidification of at least part of said mixture.

This enables to material to be stabilised in a suitable form, such as pellets or a sheet, for supplying to manufacturers making light emitting devices from the precursor material at a different location.

At least one said matrix material may comprise at least one polymer.

The mixture may include electrically conductive particles.

By adding electrically conductive particles to the mixture, this provides the advantage of increasing the efficiency of electroluminescent devices made from the precursor material. In particular, because the system does not rely on matching the work functions of respective electrodes to energy levels of organic material, multidomain devices can be achieved by introducing conductive particulate material into the system. The same particulate will see p-doping on one side and n-doping on the opposite side. Particles dispersed in the mixture therefore create multiple light emitting domains. The provision of multiple light emitting domains results in higher current efficiency for very similar voltage requirements.

According to another aspect of the present invention, there is provided a method of forming a light emitting region of an electroluminescent device from a precursor material provided by means of a method as defined above.

The method may comprise extruding at least part of said light emitting region.

The method may comprise moulding at least part of said light emitting region.

The method may further comprise applying an electric field to at least part of said mixture at a temperature at which ions in the system are mobile and capable of participating in the electrochemical doping and subsequently allowing the said mixture to cool so that electrochemically doped regions resulting from electric field application are maintained upon electric field removal.

This provides the advantage of enabling the electroluminescent device to be switched on and off more quickly than a device in which the ionic layers have to be formed each time the device is switched on.

A preferred embodiment of the invention will now be described, by way of example only and not in any limitative sense, with reference to the accompanying drawings, in which:-
Figure 1 is a schematic representation of a material processing apparatus for providing a precursor material by means of a process embodying the present invention;
Figure 2 is a plan view of an extruder device of the material processing apparatus of Figure 1;
Figure 3 is a side view of the extruder of Figure 2; and
Figures 4A to 4C explain the operation of a light emitting device having a light emitting region formed by means of the material processing apparatus of Figure 1.

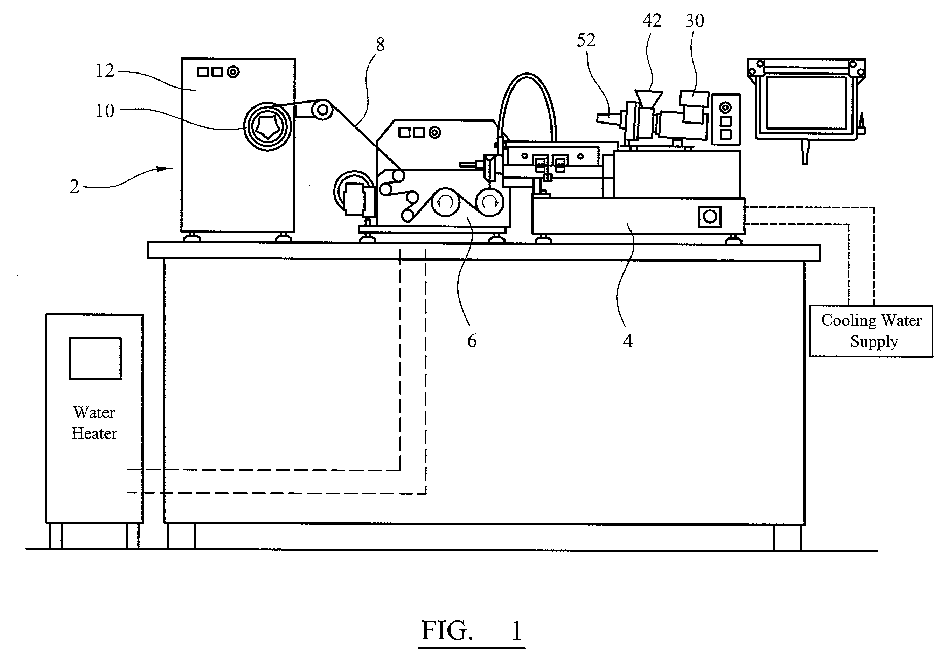

Referring to Figure 1, a material processing apparatus 2 has a twin screw extruder 4 for providing a mixture of an electroluminescent organic semiconductor material, a matrix material such as a polymer, and an ionic material for supplying positive and negative ions for contributing to electrochemical doping of the organic semiconductor material, such that at least the matrix material, and preferably the entire mixture, is in a molten state. The molten mixture can then either be solidified into pellets directly from the extruder 4 for subsequent processing at a different location, or fed to a sheet forming unit 6 which forms a sheet 8 of solidified electroluminescent mixture which can then be wound onto a roll 10 by means of a windup unit 12. In a preferred embodiment, the electroluminescent material is itself an organic semiconductor material, but it will be appreciated by persons skilled in the art that separate electroluminescent materials and organic semiconductor materials can be used. For example, inorganic electroluminescent materials, for example quantum dot materials such as cadmium sulphide, cadmium selenide, or cadmium selenide and zinc sulphide combinations can be used.

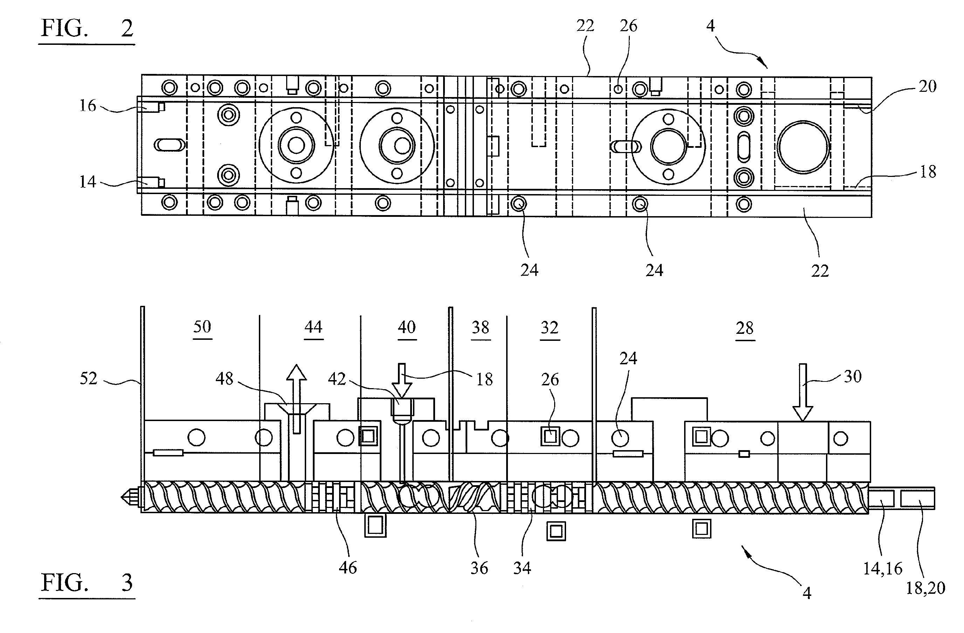

Referring to Figures 2 and 3, the extruder 4 comprises a pair of screws 14, 16 mounted for rotation about generally parallel axes 18, 20 respectively within a housing 22 having a series of heaters 24 and temperature sensors 26 to enable the temperature of different zones of the housing to be carefully controlled as the molten mixture is conveyed through the housing 22 by means of the screws 14, 16. The housing 22 defines a first feed zone 28 for receiving pellets of polymer matrix material (not shown) via a first inlet 30, and a melt zone 32 in which the polymer matrix material is subjected to shear by interleaved discs 34 of the screws 14, 16 and heated to bring the polymer matrix material to a molten state. The profile of the screws 14, 16 is inclined forwards in the first feed zone 28 so that material is conveyed towards the melt zone 32.

A part 36 of each screw 14, 16 is inclined backwards relative to the direction of propagation, in order to form a melt seal 38 to minimise leakage of molten material from the melt zone 32, and a liquid solution of electroluminescent organic semiconductor material containing ionic material for providing positive and negative ions for contributing to electrochemical doping of the organic semiconductor material dissolved in a suitable solvent such as toluene is injected into the molten polymer matrix material in a second feed zone 40 via a second inlet 42. The housing has a mix zone 44 in which the electroluminescent polymer solution and molten polymer matrix material are subjected to shear by means of interleaved discs 46 of the screws 14, 16, and excess solvent can be vented through an outlet 48 and recovered for reuse.

The molten mixture then passed to an extrusion zone 50 where it is discharged from an extrusion die 52 in the form of pellets or fed into the sheet forming unit 6 to form sheet 8 (Figure 1).

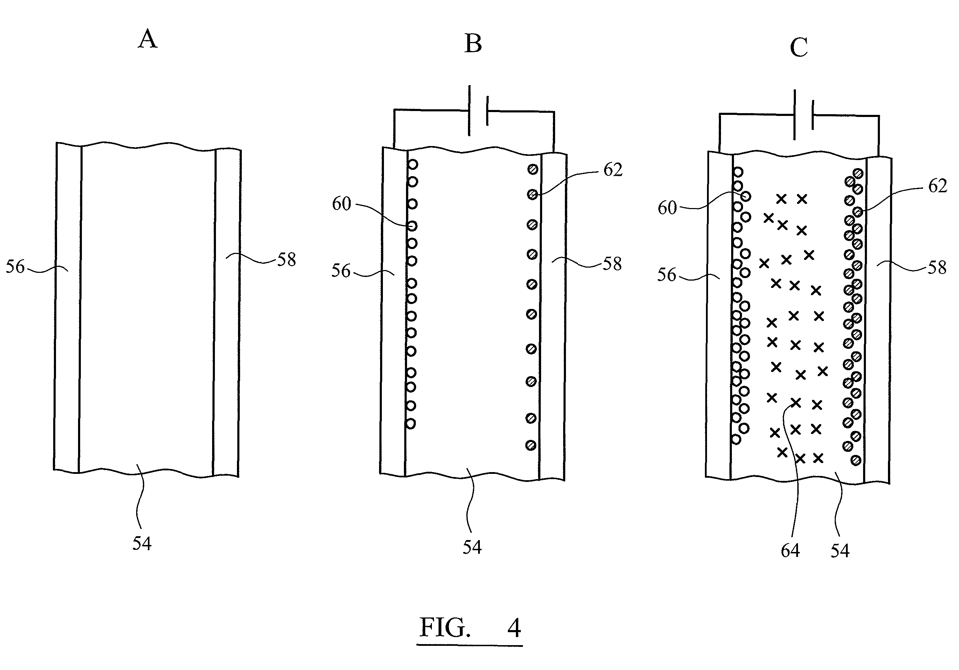

In order to form a light emitting device from the material generated by the material processing apparatus 2 shown in Figure 1, material from the previously solidified sheet 8 is dissolved in a suitable solvent such as toluene, or the molten mixture is formed directly from the extruder 4 or via a moulding device (not shown) into a suitable shape. A light emitting region 54 is then formed, as shown in greater detail in Figures 4A to 4C, by applying an electric field to the molten mixture by means of suitable electrodes 56, 58, as shown in Figure 4A, in which the ionic material and electroluminescent material is initially distributed relatively uniformly throughout the molten mixture. As the electric field is applied, as shown in Figure 4B, charge is injected from the electrodes 56, 58 into the electroluminescent organic semiconductor, so that the semiconductor material becomes positively charged adjacent anode 56 and negatively charged adjacent cathode 58. At the same time, the ionic material supplies negative ions 60 which concentrate in the region adjacent the anode 56, and positive ions 62 which concentrate in the region adjacent the cathode 58, thereby neutralising the respective charges on the surrounding organic semiconductor material. As shown in Figure 4C, the applied voltage subsequently causes holes to move from the anode 56 towards the cathode 58, and electrons to move from the cathode 58 towards the anode 56, and between the regions 60, 62 of n and p type doping, holes and electrons combine to form neutral pairs 64, which radiatively decay and emit visible light. During application of the electric field, the mixture is allowed to set, as a result of which an excess of negative ions 60 remain located adjacent to the anode 56, and an excess of positive ions 62 remain located adjacent to the cathode 58. As a result, the electroluminescent device incorporating the light emitting region 54 switches on and off more quickly than a device in which the ionic material is uniformly distributed throughout the light emitting layer 54, since the layers 60, 62 of ions material adjacent to the respective electrodes 56, 58 do not need to be built up by application of a voltage.

The effect of the layers 60, 62 of ions is to increase the electrical conductivity of the respective regions in which they are located, which in turn has the effect of increasing the proportion of the applied voltage which is applied to the middle region containing the electron/hole pairs 62.

This therefore enables a thick layer of electroluminescent material to be operated at a lower applied voltage. In addition, conductive particles such as indium tin oxide (ITO), gold or aluminium can be distributed in the mixture. This enables multidomain devices to be achieved because particles will see p-doping on one side and n-doping on the opposite side. Particles dispersed in the mixture therefore create multiple light emitting domains. The provision of multiple light emitting domains results in higher current efficiency for very similar voltage requirements.

### Example

Polystyrene pellets were fed into a twin screw extruder 4 at a rate of 0.6gm/minute, and the screws 14, 16 were caused to rotate at a rate of 50rpm. A solution consisting of 737.6mg of electroluminescent organic semiconductor material in the form of soluble phenyl-substituted PPV sold by Merck KGaA under the name PDY-132 (Superyellow), 4456.8mg of ionic liquid trihexyltetradecylphosphoniumbis (trifluoromethylsulfonyl) amide, and a solvent consisting of 94ml of toluene were provided. The first feed zone 28 of the extruder 4 was maintained at a temperature of 165 degrees C, and the melt zone 32 and liquid feed zone 40 are maintained at a temperature of 172 degrees C. The above solution was them pumped into inlet 42 at a rate of 5ml/minute, and the mix zone 44 and extrusion zone 50 were maintained at a temperature of 175 degrees C and the extrusion die 52 at 120 degrees C. The extruded film material was then supplied to sheet forming unit 6 and the sheet 8 was then collected from the wind up unit 12 of the material processing apparatus 2.

1.74gm of the sheet 8 was then dissolved in a solution of 30ml anhydrous toluene, and a sheet of indium tin oxide (ITO) coated glass was then cleaned using acetone, isopropyl alcohol and ultrasonic cleaning equipment and the substrate then baked dry. The toluene and sheet solution was placed in the centre of the glass and the glass was spun at 2000 rpm using a spin coater, in order to form a thin layer of film material. The toluene was then removed by evaporation and rotation of the substrate. The coated substrate was then placed in an evaporation system, the chamber of which was then pumped down to 3 x 10⁻⁶ mBar. Aluminium was then sublimated onto the substrate as it was rotated to ensure an even coverage, to form a light emitting layer for an electroluminescent device.

It will be appreciated by persons skilled in the art that the above embodiment has been described by way of example only, and not in any limitative sense, and that various alterations and modifications are possible without departure from the scope of the invention as defined by the appended claims. For example, certain electroluminescent or non-electroluminescent organic semiconductor materials also have ion supplying properties, as a result of which the addition of separate ionic material is not necessary.

## Claims

1. A method of manufacturing a precursor material for use in forming a light emitting region of an electroluminescent device, the method comprising providing a mixture of at least one matrix material and at least one electroluminescent material, wherein at least part of at least one said matrix material is in a molten state and the mixture includes at least one organic semiconductor material and at least one ionic material for providing positive ions and negative ions for contributing to electrochemical doping of at least one said organic semiconductor material.

2. A method according to claim 1, wherein at least one said ionic material comprises at least one organic semiconductor material.

3. A method according to claim 1 or 2, further comprising heating at least part of at least one said matrix material to a molten state thereof and adding at least one said electroluminescent material and/or at least one said organic semiconductor material to said matrix material in said molten state.

4. A method according to any one of the preceding claims, wherein at least one said electroluminescent material and/or at least one said organic semiconductor material is added in solution form to said matrix material.

5. A method according to any one of the preceding claims, further comprising adding at least one plasticiser to at least one said matrix material.

6. A method according to any one of the preceding claims, further comprising causing solidification of said mixture.

7. A method according to any one of the preceding claims, wherein at least one said matrix material comprises at least one polymer.

8. A method according to any one of the preceding claims, wherein said mixture includes electrically conductive particles.

9. A method of forming a light emitting region of an electroluminescent device from a precursor material provided by means of a method according to any one of the preceding claims.

10. A method according to claim 9, comprising extruding at least part of said light emitting region.

11. A method according to claim 9 or 10, comprising moulding at least part of said light emitting region.

12. A method according to any one of claims 9 to 11, further comprising applying an electric field to at least part of said mixtureat a temperature at which ions in the system are mobile and capable of participating in the electrochemical doping and subsequently allowing the said mixture to cool so that electrochemically doped regions resulting from electric field application are maintained upon electric field removal.
